# EUROPEAN PATENT APPLICATION

(11) **EP 1 981 036 A1**
(43) Date of publication of application: **15.10.2008**
(21) Application number: 06834614.7
(22) Date of filing: 13.12.2006
(51) Int. Cl.: H01B 5/14, C01G 9/02, C23C 14/08, H01B 13/00

(54) **TRANSPARENT ELECTROCONDUCTIVE FILM AND PROCESS FOR PRODUCING TRANSPARENT ELECTROCONDUCTIVE FILM**

(30) Priority: 11.01.2006 JP 2006004270; 12.01.2006 JP 2006005433; 21.11.2006 JP 2006313893
(71) Applicant: Murata Manufacturing Co. Ltd., Nagaokakyo-shi, Kyoto 617-8555 (JP)
(72) Inventor: NAKAGAWARA, Osamu, Nagaokakyo-shi Kyoto 617-8555 (JP); SETO, Hiroyuki, Nagaokakyo-shi Kyoto 617-8555 (JP); KISHIMOTO, Yutaka, Nagaokakyo-shi Kyoto 617-8555 (JP)
(74) Representative: Laufhütte, Dieter
(86) International application number: PCT/JP2006/324859
(87) International publication number: WO 2007/080738

(57) **Abstract**

A highly economical ZnO-based transparent conductive film having a practical level of moisture resistance and properties necessary for transparent conductive films and a method for making such a film are provided.

A transparent conductive film grown on a base by doping zinc oxide (ZnO) with a Group III element includes a region having a crystal structure in which c axes are oriented in a plurality of different directions.

A transparent conductive film grown on a base by doping zinc oxide (ZnO) with a Group III element exhibits a ZnO (002) rocking curve half width of 13.5° or more.

ZnO is doped while adjusting the dose of the oxide of Group III element such that the percentage of the oxide of the Group III element in the transparent conductive film is 7 to 40 percent by weight.

The transparent conductive film is formed on a SiNx thin film on a base.

A transparent conductive film is formed on a base by a thin-film forming technique while applying a bias voltage to the base.

## Description

### Technical Field

The present invention relates to transparent conductive films and methods for making the transparent conductive films, and particularly to a transparent conductive film containing zinc oxide (ZnO) as a main component, and a method for making the transparent conductive film.

### Background Art

Recent years saw widespread use of transparent electrodes in flat panel displays, solar cells, and the like. Indium tin oxide (tin-doped indium oxide) is widely used as the material of the transparent electrodes.

However, since indium (In) is expensive and there is also concern over depletion of resources, the demand for transparent electrodes composed of a material other than indium is increasing. ZnO-based transparent electrodes incorporating an oxide (ZnO) of zinc (Zn), which is inexpensive and whose supply is steady, are now being developed as the transparent electrodes not using indium.

Note that although ZnO having a stoichiometric composition is an insulator, conductivity can be imparted to ZnO by excess electrons created by oxygen deficiencies or by doping of the Zn site. A transparent electrode containing this type of ZnO as the main component and achieving a resistivity p on the order of 10⁻⁴ Ωcm is being produced now.

However, the ZnO-based transparent conductive film has a problem in that moisture resistance is insufficient from the practical viewpoint. That is, an existing ZnO-based transparent conductive film contains many oxygen deficiencies, and there is a problem in that when the film is left in a high-humidity environment, carriers decrease due to moisture adsorption (reoxidation) onto oxygen deficiencies, thereby resulting in a higher resistance. A required moisture resistance for the transparent electrode incorporating ITO is a rate of change in resistivity of ±10% after being left in an atmosphere at 85°C and 85% RH for 720 hours; however, no ZnO-based transparent conductive films that satisfy this requirement have been found so far.

Furthermore, when a ZnO-based transparent conductive film is formed on a flexible substrate, application of which is expected to grow in the future and which allows penetration of moisture, deterioration of the transparent conductive film becomes severer due to not only the moisture from the surface of the transparent conductive film but also the moisture that passed through the flexible substrate.

To overcome this problem, various techniques have been investigated to enhance the moisture resistance of the ZnO-based transparent conductive film. These techniques can be roughly categorized into two:
(1) technique of suppressing moisture penetration from the substrate side by providing a SiN barrier film; and
(2) technique of improving the film quality (crystallinity) of ZnO by thermal deposition or the like.

However, under current conditions, no ZnO-based transparent conductive films having a practical level of moisture resistance have been obtained so far.

The following is proposed as the technique for imparting conductivity to ZnO by doping ZnO with an element:
(a) A technique of decreasing electrical resistance with good controllability by doping a ZnO film with an impurity using a molecular beam of an atom in Group IA (H), Group IIIA (B, Al, Ga, and In), or Group VII (F, Cl, I, and Br) in forming a ZnO film using a molecular beam of ZnO or molecular beams of Zn and O (refer to patent document 1);
(b) A transparent conductive film including zinc oxide doped with an element in Group VB or VIB in the periodic table, in which a transparent conductive film containing 0.1 to 10 atom% of the aforementioned element relative to the total number of atoms of the aforementioned element and zinc is formed on a substrate (refer to patent document 2);
(c) An organic EL element including an anode, a cathode, and an organic layer interposed between the anode and cathode disposed on a substrate, in which the anode is a transparent conductive film containing at least one oxide of an element selected from the group consisting of Ir, Mo, Mn, Nb, Os, Re, Ru, Rh, Cr, Fe, Pt, Ti, W, and V (refer to patent document 3);
(d) A transistor including a transparent conductive material, such as undoped conductive ZnO or conductive ZnO doped with a Group II element, a Group VII element, a Group I element, or a Group V element (refer to patent document 4);
(e) A transparent conductive film in which the ratio of the a-axis orientation to c-axis orientation in a zinc oxide thin film is 100:1, and the transparent conductive film is doped with at least one selected from Group III and Group VII elements such as aluminum, gallium, boron, and the like (refer to patent document 5); and
(f) An indium zinc oxide-based hexagonal layer compound prepared by substituting In or Zn of a hexagonal layer compound represented by general formula (ZnO)m·In₂O₃ (m = 2 to 20) with at least one element selected from the group consisting of Sn, Y, Ho, Pb, Bi, Li, Al, Ga, Sb, Si, Cd, Mg, Co, Ni, Zr, Hf, Sc, Yb, Lu, Fe, Nb, Ta, W, Te, Au, Pt, and Ge, the indium zinc oxide-based hexagonal layer compound having an average thickness of 0.001 µm to 0.3 µm and an average aspect ratio (average length of major axis/average thickness) of 3 to 1000 (refer to patent document 6).

These ZnO-based transparent conductive films also face the problems described above regarding moisture resistance.
Patent document 1: Japanese Unexamined Patent Application Publication No. 7-106615
Patent document 2: Japanese Unexamined Patent Application Publication No. 8-050815
Patent document 3: Japanese Unexamined Patent Application Publication No. 11-067459
Patent document 4: Japanese Unexamined Patent Application Publication No. 2000-150900
Patent document 5: Japanese Unexamined Patent Application Publication No. 2000-276943
Patent document 6: International Publication No. 2001/056927 Pamphlet

### Disclosure of Invention

### Problems to be Solved by the Invention

The present invention solves the above-described problems and aims to provide a highly economical ZnO-based transparent conductive film having a practical level of moisture resistance and properties necessary for transparent conductive films and a method for making such a film.

### Means for Solving the Problems

In order to solve the problems described above, the present invention (claim 1) provides the following:
a transparent conductive film grown on a base by doping zinc oxide (ZnO) with a Group III element, the transparent conductive film including a region having a crystal structure in which c axes are oriented in a plurality of different directions.

Claim 2 provides the following:
a transparent conductive film grown on a base by doping zinc oxide (ZnO) with a Group III element, in which a ZnO (002) rocking curve half width is 13.5° or more.

Claim 3 provides the transparent conductive film according to claim 1 or 2, in which the transparent conductive film is formed as a thin film while applying a bias voltage to the base.

Claim 4 provides the transparent conductive film according to claim 3, in which formation of the thin film is conducted by one technique selected from the group consisting of a sputtering technique, a vapor deposition technique, an evaporation ion plating technique, a laser ablation technique, and an arc plasma deposition technique.

Claim 5 provides the transparent conductive film according to any one of claims 1 to 4, in which zinc oxide (ZnO) is contained as a main component, and an oxide of the Group III element is contained in an amount of 7 to 40 percent by weight.

Claim 6 provides the transparent conductive film according to any one of claims 1 to 5, in which the transparent conductive film is formed on a SiNx thin film on the base.

Claim 7 provides the transparent conductive film according to any one of claims 1 to 6, in which the base contains, as a major component, at least one selected from the group consisting of glass, quartz, sapphire, Si, SiC, polyethylene terephthalate (PET), polyethylene naphthalate (PEN), polyether sulfone (PES), polyimide, a cycloolefin polymer, and polycarbonate.

Claim 8 provides the transparent conductive film according to any one of claims 1 to 7, in which the Group III element is at least one selected from the group consisting of Ga, Al, and In.

Claim 9 provides a method for making a transparent conductive film containing zinc oxide (ZnO) and a Group III element, the method including:
a step of forming, on a base, a transparent conductive film including a region having a crystal structure in which c axes are oriented in a plurality of different directions by using a starting material containing zinc oxide (ZnO) and an oxide of the Group III element and by conducting deposition on the base by a thin-film forming technique such that the dose of the oxide of the Group III element is in the range of 7 to 40 percent by weight.

Claim 10 provides a method for making a transparent conductive film containing zinc oxide (ZnO) and a Group III element, the method including:
a step of forming, on a base, a transparent conductive film having a ZnO (002) rocking curve half width of 13.5° or more by using a starting material containing zinc oxide (ZnO) and an oxide of the Group III element and by conducting deposition on the base by a thin-film forming technique such that the dose of the oxide of the Group III element is in the range of 7 to 40 percent by weight.

Claim 11 provides a method for making a transparent conductive film containing zinc oxide (ZnO) and a Group III element, the method including:
a step of forming, on a base, a transparent conductive film including a region having a crystal structure in which c axes are oriented in a plurality of different directions by using a sintered target including a composition containing zinc oxide (ZnO) and an oxide of the Group III element and by conducting deposition on the base by one technique selected from the group consisting of a sputtering technique, a vapor deposition technique, an evaporation ion plating technique, a laser ablation technique, and an arc plasma deposition technique such that the dose of the oxide of the Group III element is in the range of 7 to 40 percent by weight.

Claim 12 provides a method for making a transparent conductive film containing zinc oxide (ZnO) and a Group III element, the method including:
a step of forming, on a base, a transparent conductive film having a ZnO (002) rocking curve half width of 13.5° or more by using a sintered target including a composition containing zinc oxide (ZnO) and an oxide of the Group III element and conducting deposition on the base by one technique selected from the group consisting of a sputtering technique, a vapor deposition technique, an evaporation ion plating technique, a laser ablation technique, and an arc plasma deposition technique such that the dose of the oxide of the Group III element is in the range of 7 to 40 percent by weight.

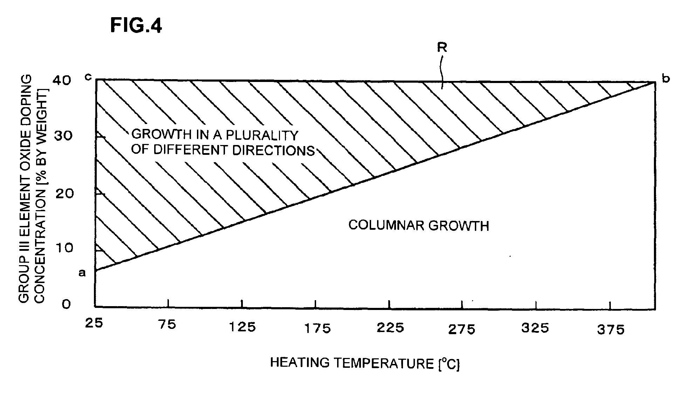

Claim 13 provides the method for making the transparent conductive film containing zinc oxide (ZnO) and the Group III element according to any one of claims 9 to 12, in which a relationship between a temperature of the base onto which the transparent conductive film is formed by the thin-film forming technique and the dose of the oxide of the Group III element is within the range defined by points a, b, and c in Fig. 4.

Claim 14 provides the method for making the transparent conductive film containing zinc oxide (ZnO) and the Group III element according to any one of claims 11 to 13, in which in conducting deposition on the base by one technique selected from the group consisting of a sputtering technique, a vapor deposition technique, an evaporation ion plating technique, a laser ablation technique, and an arc plasma deposition technique, a bias voltage is applied to the base.

Claim 15 provides the method for making the transparent conductive film containing zinc oxide (ZnO) and the Group III element according to any one of claims 9 to 14, in which the deposition by the thin-film forming technique is conducted in a vacuum chamber at a backpressure of 1 × 10⁻⁴ Pa or less.

Claim 16 provides a method for making a transparent conductive film, the method including forming a SiNx thin film on a base and then forming the transparent conductive film on the SiNx thin film on the base by the method according to any one of claims 9 to 15.

Claim 17 provides the method for making the transparent conductive film according to any one of claims 9 to 16, in which the base contains, as a major component, at least one selected from the group consisting of glass, quartz, sapphire, Si, SiC, polyethylene terephthalate (PET), polyethylene naphthalate (PEN), polyether sulfone (PES), polyimide, a cycloolefin polymer, and polycarbonate.

Claim 18 provides the method for making the transparent conductive film according to any one of claims 9 to 17, in which the Group III element is at least one selected from the group consisting of Ga, Al, and In.

### Advantages of the Invention

Since the transparent conductive film of the present invention (Claim 1) is a transparent conductive film grown on a base by doping zinc oxide (ZnO) with a Group III element, the transparent conductive film including a region having a crystal structure in which c axes are oriented in a plurality of different directions, it is possible to provide a ZnO-based transparent conductive film having moisture resistance of a practical level and excellent economical efficiency.

The reasons why the transparent conductive film of claim 1 achieves excellent moisture resistance are considered as follows. In an existing transparent conductive film having a uniaxially oriented structure where crystals grown into a columnar shape have their c axes oriented in the same direction, moisture penetrates to the interior through grain boundaries and degrades the moisture resistance. In contrast, in the transparent conductive film including a region having a crystal structure in which c axes are oriented in a plurality of different directions, this change in film structure suppresses reoxidation of oxygen deficiencies by moisture.

In the transparent conductive film of the present invention, the regions other than the region having the crystal structure in which the c axes are oriented in a plurality of different directions may include an amorphous region or a region having a so-called quasi-crystal structure between the amorphous structure and the crystal structure.

The transparent conductive film of claim 2 is a transparent conductive film grown on a base by doping zinc oxide (ZnO) with a Group III element, in which a ZnO (002) rocking curve half width is 13.5° or more. Since the extent that the c axes become oriented in the same direction is small, it is possible to suppress reoxidation of the oxygen deficiencies. Thus, it is possible to provide a ZnO-based transparent conductive film having moisture resistance of a practical level and excellent economical efficiency.

In the present invention, the ZnO (002) rocking curve half width is required to be 13.5° or more since in a ZnO film having a ZnO (002) rocking curve half width of 13.5° or more, the extent that the c axes become oriented in the same direction can be sufficiently decreased to a level that can suppress or prevent reoxidation of the oxygen deficiencies.

As in the transparent conductive film of claim 3, when the transparent conductive film of claim 1 or 2 is formed as a thin film by applying a bias voltage to the base, it becomes possible to increase the moisture resistance while suppressing the dose of the Group III element. Thus, a transparent conductive film having a low resistivity and excellent moisture resistance can be formed.

As in the transparent conductive film of claim 4, when the formation of the thin film in the invention of claim 3 is conducted by one technique selected from the group consisting of a sputtering technique, a vapor deposition technique, an evaporation ion plating technique, a laser ablation technique, and an arc plasma deposition technique, a transparent conductive film having a low resistivity and excellent moisture resistance can be formed at higher efficiency.

As in the transparent conductive film of claim 5, when zinc oxide (ZnO) is contained as a main component and an oxide of the Group III element is contained in an amount of 7 to 40 percent by weight in any one of the inventions in claims 1 to 4, it becomes possible to efficiently form a transparent conductive film including a region having a crystal structure in which c axes are oriented in a plurality of different directions or a transparent conductive film having a ZnO (002) rocking curve half width of 13.5° or more. Thus, the effects of the present invention can be further strengthened.

The reasons for setting the dose of the oxide of the Group III element in the range of 7 to 40 percent by weight are as follows. At a dose of less than 7 percent by weight, it becomes difficult to efficiently form a transparent conductive film including a region having a crystal structure in which c axes are oriented in a plurality of different directions or a transparent conductive film having a ZnO (002) rocking curve half width of 13.5° or more. At a dose exceeding 40 percent by weight, it becomes difficult to obtain a transparent electrode having a low resistivity required for practical application.

When the transparent conductive film of any one of claims 1 to 5 is formed on a SiNx thin film on the base as in the transparent conductive film of claim 6 and when the base is of a type that allows penetration of water, such as a flexible substrate composed of a resin material, it becomes possible to efficiently suppress or prevent moisture penetrating the flexible substrate (base) from reaching the transparent conductive film. Thus, it becomes possible to ensure sufficient moisture resistance and further strengthen the advantages of the present invention.

In the present invention, the base may contain, as a major component, at least one selected from the group consisting of glass, quartz, sapphire, Si, SiC, polyethylene terephthalate (PET), polyethylene naphthalate (PEN), polyether sulfone (PES), polyimide, a cycloolefin polymer, and polycarbonate, as in claim 7. According to the present invention, a ZnO-based transparent conductive film having a practical level of moisture resistance and economical efficiency can be formed on the base composed of these materials.

When at least one selected from the group consisting of Ga, Al, and In is used as the Group III element in any one of claims 1 to 7 as in the transparent conductive film of claim 8, a ZnO-based transparent conductive film having a practical level of moisture resistance and economical efficiency can be formed more reliably.

Note that from the standpoint of achieving sufficiently low resistivity, it is most preferable to use Ga as the Group III element (dopant), but effects similar to that achieved by use of Ga can be obtained by using other Group III elements such as Al and In.

Since in the method for making the transparent conductive film in Claim 9, the starting material containing zinc oxide (ZnO) and an oxide of the Group III element is used and deposition on a base is conducted by a thin-film forming technique such that the dose of an oxide of the Group III element is in the range of 7 to 40 percent by weight, a transparent conductive film including a region having a crystal structure in which the c axes are oriented in a plurality of different directions can be easily and reliably formed on a base without requiring complicated processes.

Note that in the invention in claim 9, it is possible to use various techniques as the thin-film forming technique, including a sputtering technique, a vapor deposition technique, an evaporation ion plating technique, a laser ablation technique, and an arc plasma deposition technique, a chemical vapor deposition technique, and a sol-gel technique.

Since the method for making the transparent conductive film according to claim 10 includes a step of forming a transparent conductive film having a ZnO (002) rocking curve half width of 13.5° or more by using a starting material containing zinc oxide (ZnO) and an oxide of the Group III element and by conducting deposition on a base by a thin-film forming technique such that the dose of an oxide of the Group III element is in the range of 7 to 40 percent by weight, a transparent conductive film including a region having a crystal structure in which the c axes are oriented in a plurality of different directions can be easily and reliably formed on a base without requiring complicated processes.

Note that in the invention in claim 10 also, it is possible to use various techniques as the thin-film forming technique, including a sputtering technique, a vapor deposition technique, an evaporation ion plating technique, a laser ablation technique, and an arc plasma deposition technique, a chemical vapor deposition technique, and a sol-gel technique.

The method for making the transparent conductive film containing zinc oxide (ZnO) and a Group III element according to claim 11 includes a step of forming a region having a crystal structure in which c axes are oriented in a plurality of different directions by using a sintered target including a composition containing zinc oxide (ZnO) and an oxide of the Group III element and conducting deposition on a base by one technique selected from the group consisting of a sputtering technique, a vapor deposition technique, an evaporation ion plating technique, a laser ablation technique, and an arc plasma deposition technique such that the dose of the oxide of the Group III element is in the range of 7 to 40 percent by weight. Thus, an apparatus having substantially the same structure as a common apparatus for conducting the thin-film formation technique described above can be used to efficiently and economically form a ZnO-based transparent conductive film having a practical level of moisture resistance.

The relationship between the dose of the oxide of the Group III element in the ZnO film and the ratio of the oxide of the Group III element in the target may be investigated in advance. By using a sintered target including a composition containing zinc oxide (ZnO) and the oxide of the Group III element at a particular ratio in conducting deposition by the thin-film forming technique, a ZnO film having a target dose can be reliably obtained.

The method for making the transparent conductive film containing zinc oxide (ZnO) and the Group III element of claim 12 includes a step of forming a transparent conductive film having a ZnO (002) rocking curve half width of 13.5° or more by using a sintered target including a composition containing zinc oxide (ZnO) and an oxide of the Group III element and by conducting deposition on a base by one technique selected from the group consisting of a sputtering technique, a vapor deposition technique, an evaporation ion plating technique, a laser ablation technique, and an arc plasma deposition technique such that the dose of the oxide of the Group III element is in the range of 7 to 40 percent by weight. Thus, an apparatus having substantially the same structure as a common apparatus for conducting the thin-film formation technique described above can be used to efficiently and economically form a ZnO-based transparent conductive film having a practical level of moisture resistance.

By adjusting the relationship between a temperature of the base onto which the transparent conductive film is formed by the thin-film forming technique and the dose of the oxide of the Group III element in the invention according to any one of claims 9 to 12 to be within the range defined by points a, b, and c in Fig. 4 as in the method of claim 13, it becomes possible to efficiently form a transparent conductive film including a region having a crystal structure in which c axes are oriented in a plurality of different directions or a transparent conductive film having a ZnO (002) rocking curve half width of 13.5° or more. Thus, the effects of the present invention can be further strengthened.

That is, during formation of the transparent conductive film by the thin-film deposition technique described above, the temperature of the base is controlled to be within the range defined by points a, b, and c in Fig. 4 according to the dose of the oxide of the Group III element. IN this manner, the crystal state of the ZnO film (transparent conductive film) can be controlled, and a transparent conductive film including a region having a crystal structure in which c axes are oriented in a plurality of different directions or a transparent conductive film having a ZnO (002) rocking curve half width of 13.5° or more can be efficiently formed. Thus, the effects of the present invention can be further strengthened.

The inclination of the line connecting points a and b in Fig. 4 can be adjusted (changed) according to the deposition conditions. By adequately controlling the inclination of the line connecting points a and b, the crystal state of the ZnO film can be more efficiently controlled, and a transparent conductive film with enhanced properties can be obtained.

As in the method for making the transparent conductive film of claim 14, when a bias voltage is applied to the base in conducting deposition on the base by one technique selected from the group consisting of a sputtering technique, a vapor deposition technique, an evaporation ion plating technique, a laser ablation technique, and an arc plasma deposition technique in the invention in any one of claims 11 to 13, it becomes possible to increase the moisture resistance while suppressing the dose of the Group III element. Thus, a transparent conductive film having a low resistivity and excellent moisture resistance can be reliably formed.

As in the method for making the transparent conductive film of claim 15, when the deposition by the thin-film forming technique is conducted in a vacuum chamber at a backpressure of 1 × 10⁻⁴ Pa or less in the invention in any one of claims 9 to 14, a ZnO-based transparent conductive film having a practical level of resistivity and moisture resistance can be formed more reliably.

As in the method for making the transparent conductive film of claim 16, when a SiNx thin film is formed on a base and then a transparent conductive film is formed on the SiNx thin film on the base by the method according to any one of claims 9 to 15 and when the base is of a type that allows penetration of water, such as a flexible substrate composed of a resin material, it becomes possible to efficiently suppress or prevent moisture penetrating the flexible substrate (base) to reach the transparent conductive film. Thus, it becomes possible to ensure sufficient moisture resistance and further strengthen the advantages of the present invention.

In the method for making the transparent conductive film according to the present invention, the base may contain, as a major component, at least one selected from the group consisting of glass, quartz, sapphire, Si, SiC, polyethylene terephthalate (PET), polyethylene naphthalate (PEN), polyether sulfone (PES), polyimide, a cycloolefin polymer, and polycarbonate, as in claim 17. According to the method for making the transparent conductive film of the present invention, a ZnO-based transparent conductive film having a practical level of moisture resistance and excellent economical efficiency can be formed on a substrate composed of these materials.

As in the method for making the transparent conductive film of claim 18, when the Group III element is at least one selected from the group consisting of Ga, Al, and In in the invention of any one of claims 9 to 17, a ZnO-based transparent conductive film having a practical level of moisture resistance and excellent economical efficiency can be formed.

Note that from the standpoint of achieving sufficiently low resistivity, it is most preferable to use Ga as the Group III element (dopant), but effects similar to that achieved by use of Ga can be obtained by using other Group III elements such as Al and In.

Although In is an expensive substance, it is only used as the dopant. Thus, compared to the related art in which In is used as the main component, the cost can be notably reduced.

### Brief Description of the Drawings

[Fig. 1] Fig. 1 is a graph showing the relationship between the Ga₂O₃ dopant concentration in the ZnO film (transparent conductive film) and the resistivity and the like.
[Fig. 2] Fig. 2 is a graph showing the relationship between the time and the rate of change in resistivity in the case where moisture resistance test (85°C and 85% RH) is conducted on the existing ZnO film (transparent conductive film).
[Fig. 3] Fig. 3 is a graph showing the relationship between the time and the rate of change in resistivity in the case where moisture resistance test (85°C and 85% RH) is conducted on a ZnO film (transparent conductive film) of the present invention.
[Fig. 4] Fig. 4 is a graph showing the relationship between the Group III oxide dopant concentration and the heating temperature in making the transparent conductive film of the present invention.
[Fig. 5] Fig. 5 is a chart showing the relationship between the Ga₂O₃ dopant concentration in the ZnO film (transparent conductive film) and the orientation of the c axes.
[Fig. 6] Fig. 6 is a transmission electron micrograph of a sample with a Ga₂O₃ dopant concentration of 4.1 wt%, which is outside the range of the present invention.
[Fig. 7] Fig. 7 is a transmission electron micrograph of a sample with a Ga₂O₃ dopant concentration of 22.8 wt%, which is within the range of the present invention.
[Fig. 8] Fig. 8 is a diagram schematically showing the crystal structure of the sample with a Ga₂O₃ dopant concentration of 4.1 wt%, which is outside the range of the present invention.
[Fig. 9] Fig. 9 is a diagram schematically showing the crystal structure of the sample with a Ga₂O₃ dopant concentration of 22.8 wt%, which is within the range of the present invention.
[Fig. 10] Fig. 10 is an atomic force micrograph of showing the surface condition of the sample with a Ga₂O₃ dopant concentration of 4.1 wt%, which is outside the range of the present invention.
[Fig. 11] Fig. 11 is an atomic force micrograph of showing the surface condition of the sample with a Ga₂O₃ dopant concentration of 22.8 wt%, which is within the range of the present invention.
[Fig. 12] Fig. 12 is an X-ray ZnO (002) pole figure of the sample with a Ga₂O₃ dopant concentration of 4.1 wt% outside the range of the present invention.
[Fig. 13] Fig. 13 is an X-ray ZnO (002) pole figure of the sample with a Ga₂O₃ dopant concentration of 12.6 wt% within the range of the present invention.
[Fig. 14] Fig. 14 is an X-ray ZnO (002) pole figure of the sample with a Ga₂O₃ dopant concentration of 22.8 wt% within the range of the present invention.
[Fig. 15] Fig. 15 is a graph showing the relationship between the Ga₂O₃ dopant concentration in the ZnO film (transparent conductive film) and the ZnO (002) rocking curve half width.
[Fig. 16] Fig. 16 is a graph showing the relationship between the time and the rate of change in resistivity in the case where moisture resistance test (85°C and 85% RH) is conducted on a ZnO film (transparent conductive film) on a flexible substrate (PEN substrate) in EXAMPLE 2 of the present invention.
[Fig. 17] Fig. 17 is a graph showing the relationship between the time and the rate of change in resistivity in the case where moisture resistance test (85°C and 85% RH) is conducted on a ZnO film (transparent conductive film) on a flexible substrate (PEN substrate) in EXAMPLE 4 of the present invention.
[Fig. 18] Fig. 18 is a chart showing the relationship between the bias voltage applied to the substrate and the orientation of the c axes of the ZnO film (transparent conductive film).
[Fig. 19] Parts (a) to (d) are X-ray ZnO (002) pole figures of transparent conductive films prepared by applying a bias voltage of -80 to +40 V onto the substrate.
[Fig. 20] Fig. 20 is a transmission electron micrograph of a transparent conductive film prepared by the process described in EXAMPLE 4 of the present invention.
[Fig. 21] Fig. 21 is a graph showing the relationship among the bias voltage to the substrate, the resistivity, and the Ga₂O₃ dopant concentration.

### Reference Numerals

- B: grain boundary
- G: grain
- R: region

### Best Mode for Carrying Out the Invention

The present invention will now be described in detail by describing embodiments of the present invention.

In a transparent conductive film of the present invention in which zinc oxide (ZnO) is doped with a Group III element and grown on a substrate, representative examples of the dopant (Group III element) for ZnO are Ga, Al, and In.

When ZnO is doped with such a Group III element (Group III oxide), the site of divalent zinc is replaced by a trivalent cation and the excess electrons function as carriers so that n-type conductivity is exhibited. If a film is grown by a technique such as a sputtering technique, a vapor deposition technique, an evaporation ion plating technique, a laser ablation technique, an arc plasma deposition technique, a chemical vapor deposition technique, a sol-gel technique, or the like such that the oxygen supply is below the stoichiometric ratio, the resulting film will contain oxygen deficiencies and electrons will serve as carriers, thereby imparting n-type conductivity.

Thus, ZnO doped with a Group III element is an n-type semiconductor in which carriers are supplied by addition of a donor-type impurity resulting from site substitution and by generation of electrons resulting from oxygen deficiencies.

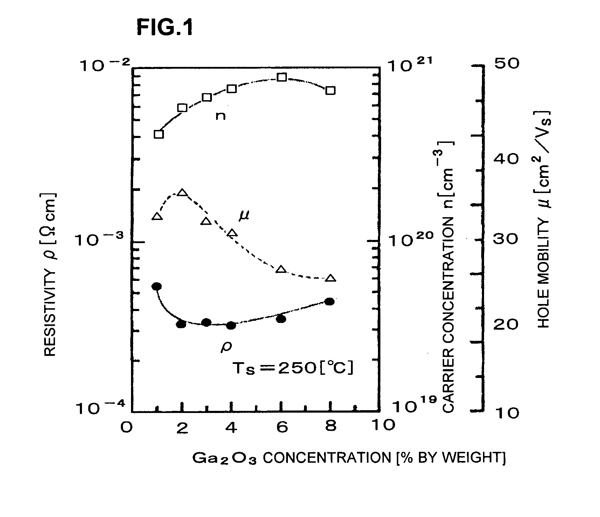

When Ga is used as a dopant for a conductor composed of zinc oxide (ZnO) doped with a Group III element, the relationship between the dopant dose and the physical properties is as reported in U. Minami et al., J. Vac. Soc. (Vacuum), vol. 47, No. 10 (2004) 734. As shown in Fig. 1, the resistivity is lowest when the dose is 2 to 4 percent by weight on a Ga₂O₃ basis. Thus, in view of applications to the transparent conductive films, it is advantageous to control the dose to 2 to 4 percent by weight so that a ZnO film having a low resistivity can be obtained.

Note that since increasing the dose relatively increases the resistivity, the widest applicable range of the dose is usually about 2 to 6 percent by weight. This is because it is advantageous to decrease the resistivity as much as possible from the standpoint of applications to transparent conductive films and thus there is no need to increase the resistivity by increasing the dose.

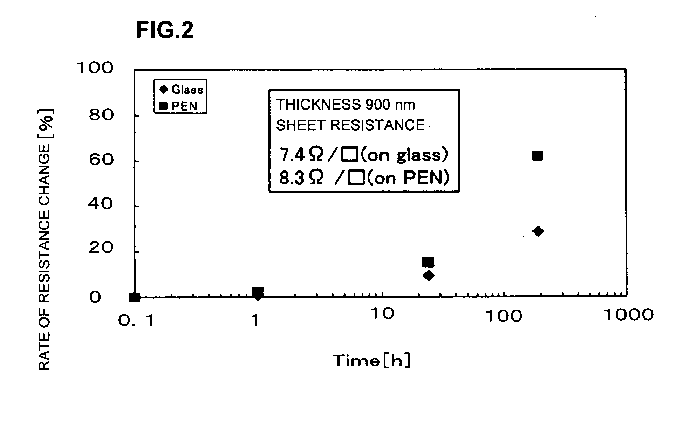

However, it has been confirmed that a ZnO film with a decreased dose undergoes significant deterioration in a moisture resistance test. For example, a ZnO film with a dose of 2 to 4 percent by weight on a Ga₂O₃ basis was subjected to moisture resistance test (85°C and 85% RH) according to the aforementioned literature, and it has been found that changes in resistance (an increase in resistivity) occurred in about 30% of ZnO films formed on a glass plate and about 60% of ZnO films formed on a flexible substrate composed of a type of plastic, polyethylene naphthalate (PEN) after 200 hours (see Fig. 2). Such a decrease in resistivity is the deterioration level not suitable for practical applications.

The present inventors have then assumed that it is highly likely that the degradation in resistivity (an increase in resistivity) of the ZnO film in the moisture resistance test is attributable to chemical instability caused by oxygen deficiencies. Thus, the present inventors have taken following measures:
(1) terminating the oxygen deficiencies by intentionally introducing water in a vacuum chamber; and
(2) promoting crystallization by heating the substrate. However, neither of these measures achieved satisfactory effects.

Thus, the present inventors have further conducted experiments and studies and found that degradation in resistivity of the ZnO film by the moisture resistance test can be notably suppressed by significantly increasing the dose of the Group III element from the dose commonly employed in the related art. Further experiments and studies have been repeated, and the present invention has been made.

As is discussed above, both site substitution and oxygen deficiencies contribute to carrier supply in ZnO; however, it is technically difficult to quantitatively analyze the degree of contribution of each factor. The present inventors have assumed that, from the qualitative viewpoint, the chemical instability can be moderated by reducing the contribution of the oxygen deficiencies as much as possible and by making dominant the contribution of the site substitution. Thus, the present inventors have significantly increased the dose of the Group III element from the dose of the related art to conduct heavy doping and studied the properties of the resulting ZnO film.

That is, an undoped ZnO sputtering target and a Ga₂O₃ pellet to be placed on the target were prepared, and sputtering was conducted while adjusting the dopant concentration by controlling the number of Ga₂O₃ pellets to be placed on the undoped ZnO sputtering target so that a ZnO film doped with Ga₂O₃ was formed on a glass substrate. The relationship between the number of Ga₂O₃ pellets and the Ga₂O₃ dopant concentration were quantitatively analyzed by ICP.

As a result, it was found that the relationship between the number of Ga₂O₃ pellets and the Ga₂O₃ dopant concentration was as follows:
(1) 1 Ga₂O₃ pellet: Ga₂O₃ dopant concentration of 4.1 wt%
(2) 1.5 Ga₂O₃ pellets: Ga₂O₃ dopant concentration of 6.5 wt%
(3) 2 Ga₂O₃ pellets: Ga₂O₃ dopant concentration of 8.1 wt%
(4) 2.5 Ga₂O₃ pellets: Ga₂O₃ dopant concentration of 10.8 wt%
(5) 3 Ga₂O₃ pellets: Ga₂O₃ dopant concentration of 12.6 wt%
(6) 5 Ga₂O₃ pellets: Ga₂O₃ dopant concentration of 22.8 wt%

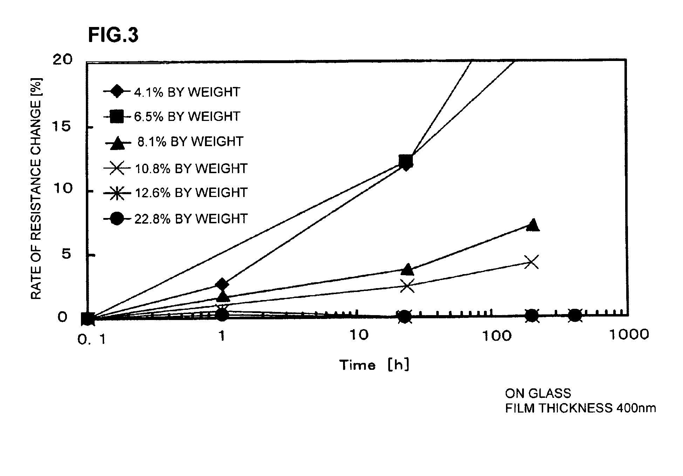

Samples having a Ga dopant concentration of 4.1 to 22.8 percent by weight prepared as above were subjected to moisture resistance test (85°C and 85% RH). As shown in Fig. 3, samples with a Ga₂O₃ dopant concentration of 8.1 percent by weight or more did not undergo significant degradation in resistivity (significant increase in rate of change in resistivity) even after 200 hours. In contrast, Samples with a dopant concentration of 4.1 percent by weight and 6.5 percent by weight below the lower limit, i.e., 7.0 percent by weight, of the dopant concentration of the present invention, exhibited a rate of change in resistivity of about 13% after 24 hours and 20% or more after 200 hours. That is, it was found that the at these dopant concentrations, degradation in resistivity was severe and that a ZnO film satisfying a practical level could not be obtained.

A ZnO film was formed on a flexible substrate composed of polyethylene naphthalate by the same process as above. In this case also, no significant degradation in resistance was observed even after 200 hours at a Ga₂O₃ dopant concentration of 7.0 percent by weight or more, but the rate of change in resistivity increased as the Ga₂O₃ dopant concentration became lower than 7.0 percent by weight, thereby giving unfavorable results.

The features of the present invention will now be described in further detail by way of specific examples.

### EXAMPLE 1

A glass substrate composed of non-alkali glass (Corning 7059) was prepared as a base. The glass substrate was cleaned with isopropyl alcohol and UV irradiation to obtain a clean surface.

A ZnO sintered target having a sintered density of 80% or more and a diameter of 6 inches was prepared as the sputtering target.

Pellets (Ga₂O₃ pellets) composed of gallium oxide (Ga₂O₃) and having a diameter of 10 mm were prepared for doping.

In EXAMPLE 1, the Ga₂O₃ pellets were placed in an erosion region on the ZnO sintered target and sputtering was conducted to form a ZnO film doped with Ga₂O₃ on a base.

The dose of Ga₂O₃ was adjusted by adjusting the number of Ga₂O₃ pellets.

In conducting sputtering, a glass substrate was set in a vacuum chamber of a sputtering apparatus, the chamber was evacuated to 5 × 10⁻⁵ Pa, and sputtering was conducted without heating the glass substrate (base).

In EXAMPLE 1, high-purity Ar gas was used as the sputtering gas, and the sputtering gas was introduced to the vacuum chamber until the pressure inside the chamber was 1 Pa.

In the method for making the transparent conductive film of the present invention, the crystal structure of the ZnO film formed can be controlled by heating the base. In such a case, it is preferable to control the relationship between the temperature of the base and the dose of the Group III element oxide in a triangular range R in Fig. 4 defined by points a, b, and c. In this manner, by adjusting the inclination of the line connecting the points a and b according to the deposition conditions, the crystal state of the ZnO film can be efficiently controlled, and a transparent conductive film having excellent properties can be obtained.

Deposition was conducted by starting sputtering under a condition of RF power: 500 W to form a ZnO film (transparent conductive film) doped with Ga at a particular proportion and having a predetermined thickness. The thickness of the ZnO film to be deposited was set to 400 nm.

The resulting ZnO film was subjected to patterning by wet etching. Then, whether the thickness of the film was ±15% of the target thickness was inspected with a stylus profilometer.

The resistivity of each sample measured by a four-probe method was as follows:
(1) 5.9 × 10⁻⁴ Ωcm when the number of Ga₂O₃ pellets was 1
(2) 9.1 × 10⁻⁴ Ωcm when the number of Ga₂O₃ pellets was 3
(3) 4.8 × 10⁻³ Ωcm when the number of Ga₂O₃ pellets was 5 The sheet resistance was as follows:

(1) 13 Ω/□ when the number of Ga₂O₃ pellets was 1
(2) 22 Ω/□ when the number of Ga₂O₃ pellets was 3
(3) 116 Ω/□ when the number of Ga₂O₃ pellets was 5

The light transmittance in a visible region was 80% or more in all cases involving 1, 3, and 5 Ga₂O₃ pellets.

The surface roughness (Rms) of the resulting ZnO film was as follows:
(1) 6.969 nm (first time) and 7.437 nm (second time) when the number of Ga₂O₃ pellets was 1
(2) 4.062 nm (first time) and 4.834 nm (second time) when the number of Ga₂O₃ pellets was 3
(3) 4.091 nm (first time) and 4.235 nm (second time) when the number of Ga₂O₃ pellets was 5
These results show that the grain growth was suppressed with the increase in dopant concentration, thereby increasing the flatness of the surface of the ZnO film.

As described in the Best Mode for Carrying Out the Invention section, the relationship between the number of Ga₂O₃ pellets and the Ga₂O₃ dopant concentration was as follows:
(1) 1 Ga₂O₃ pellet: Ga₂O₃ dopant concentration of 4.1 wt%
(2) 1.5 Ga₂O₃ pellets: Ga₂O₃ dopant concentration of 6.5 wt%
(3) 2 Ga₂O₃ pellets: Ga₂O₃ dopant concentration of 8.1 wt%
(4) 2.5 Ga₂O₃ pellets: Ga₂O₃ dopant concentration of 10.8 wt%
(5) 3 Ga₂O₃ pellets: Ga₂O₃ dopant concentration of 12.6 wt%
(6) 5 Ga₂O₃ pellets: Ga₂O₃ dopant concentration of 22.8 wt%

As described in the Best Mode for Carrying Out the Invention section, these samples did not undergo significant degradation in resistance (significant increase in rate of change in resistivity) even after 200 hours when the number of Ga₂O₃ pellets was 2 or more (that is, Ga₂O₃ dopant concentration of 8.1 wt% or more) and when the glass substrate was used (refer to Fig. 3).

However, for samples prepared using 1 Ga₂O₃ pellet (Ga₂O₃ dopant concentration of 4.1 wt%) and 1.5 Ga₂O₃ pellets (Ga₂O₃ dopant concentration of 6.5 wt%), the rate of change in resistivity increased with time. It was confirmed that the rate of change in resistivity after 24 hours was about 13% and that after 200 hours was 20% or more.

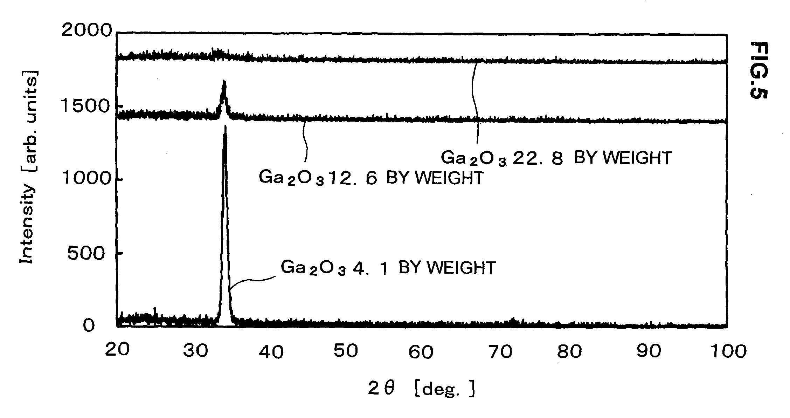

Fig. 5 is an X-ray diffractogram (θ-2θ scan) of a sample with a Ga₂O₃ dopant concentration of 4.1 wt% (1), a sample with a Ga₂O₃ dopant concentration of 12.6 wt% (5), and a sample with a Ga₂O₃ dopant concentration of 22.8 wt% (6).

As shown in Fig. 5, the intensity of the c-axis peak was high in the sample with a Ga₂O₃ dopant concentration of 4.1 wt%, but the intensity of the c-axis peak was very small in the sample with a Ga₂O₃ dopant concentration of 12.6 wt% and no c-axis peak was detected in the sample with a Ga₂O₃ dopant concentration of 22.8 wt%. These results show that the degree of c-axis orientation decreases as the Ga₂O₃ dopant concentration increases.

It can be assumed from these results that the moisture resistance of the ZnO film of the present invention is improved because the reoxidation of the oxygen deficiencies is suppressed by the increased Ga₂O₃ dopant concentration and disorientation of c axes resulting therefrom.

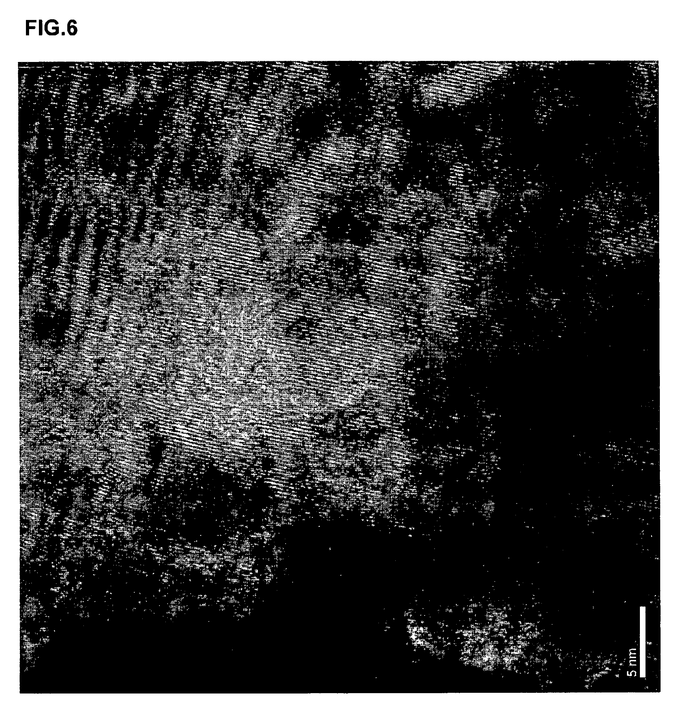

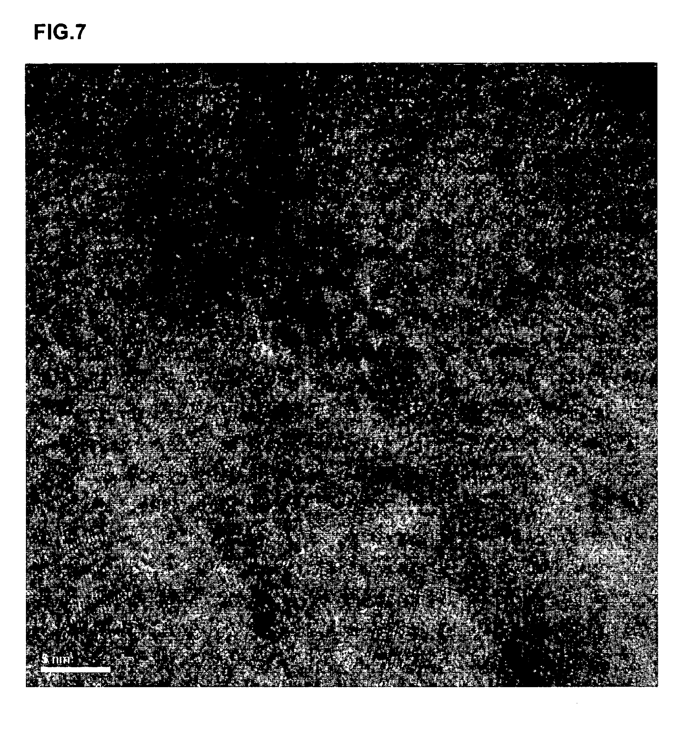

Fig. 6 is a transmission electron micrograph of a sample with a Ga₂O₃ dopant concentration of 4.1 wt%, which is outside the range of the present invention, and Fig. 7 is a transmission electron micrograph of a sample with a Ga₂O₃ dopant concentration of 22.8 wt%, which is within the range of the present invention.

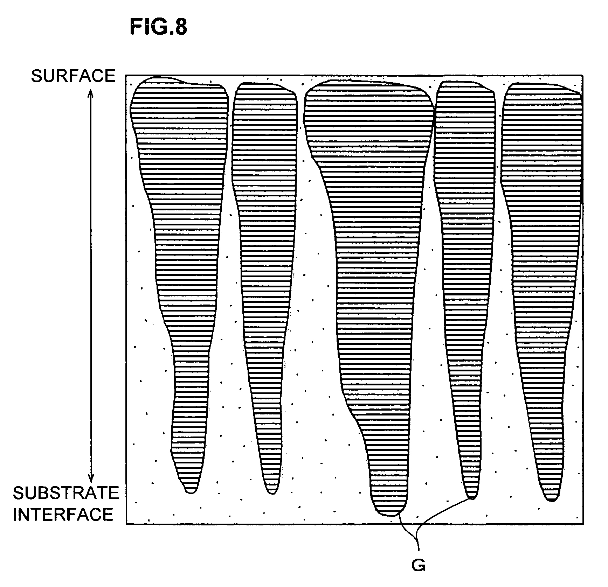

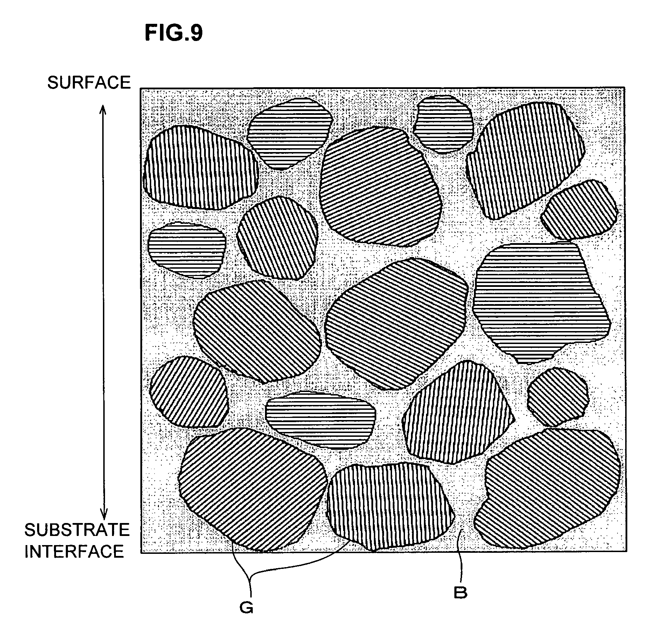

Fig. 8 is a diagram schematically showing the crystal structure of the sample with a Ga₂O₃ dopant concentration of 4.1 wt%, which is outside the range of the present invention, and Fig. 9 is a diagram schematically showing the crystal structure of the sample with a Ga₂O₃ dopant concentration of 22.8 wt%, which is within the range of the present invention.

In Figs. 8 and 9, a plurality of parallel lines in grains G schematically represent lattice spacing.

As shown in Figs. 6 and 8, in the ZnO film with a low Ga₂O₃ dopant concentration of 4.1 wt% outside the range of the present invention, the majority of c axes orient in the direction of the normal line with respect to the substrate and the c axes are oriented in the same direction. Moreover, the grains G are columnar in shape, thereby indicating typical columnar growth.

In contrast, as shown in Figs. 7 and 9, in the ZnO film with a high Ga₂O₃ dopant concentration of 22.8 wt% in the range of the present invention, the c axes are oriented in directions different from one another (Fig. 7), and the grains G are not columnar in shape (Fig. 9). Note that regions having an amorphous structure or a quasi-crystalline structure, such as the structure between amorphous and crystalline, and the like presumably exist in a grain boundary B.

Figs. 7 and 9 showing the crystal structure of the ZnO film in the range of the present invention support the idea of the present invention that because the c axes are oriented in different directions, the reoxidation of the oxygen deficiencies is inhibited and the moisture resistance is improved.

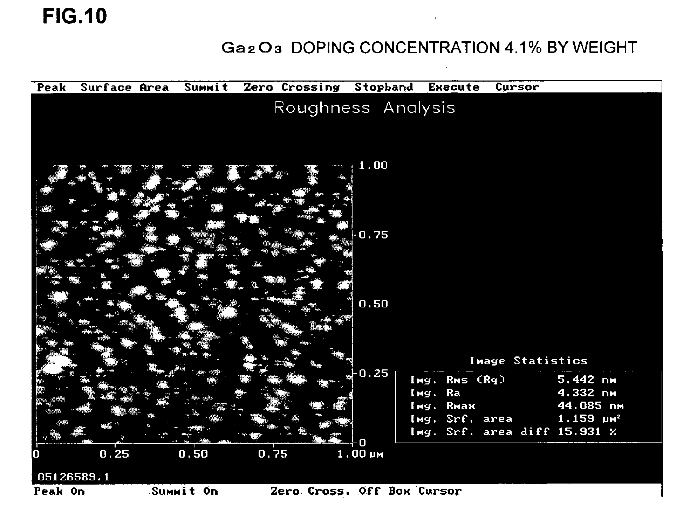

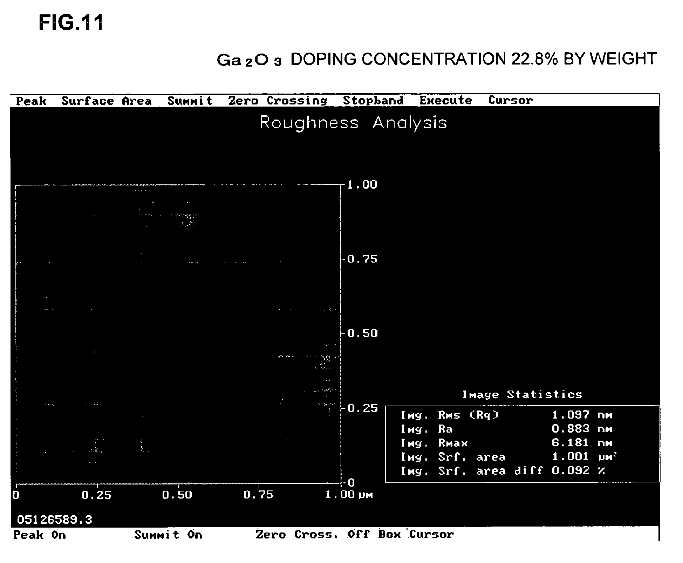

Fig. 10 is an atomic force micrograph of showing the surface condition of the sample with a Ga₂O₃ dopant concentration of 4.1 wt%, which is outside the range of the present invention, and Fig. 11 is an atomic force micrograph of showing the surface condition of the sample with a Ga₂O₃ dopant concentration of 22.8 wt%, which is within the range of the present invention.

As shown in Fig. 10, in the sample with a Ga₂O₃ dopant concentration of 4.1 wt% outside the range of the present invention, irregularities (lumpy texture) created by crystals with their c axes oriented in the same direction are observed in the surface. In contrast, in the sample with a Ga₂O₃ dopant concentration of 22.8 wt% in the range of the present invention, irregularities and grain boundaries created by crystals are not clearly observed in the surface since the c axes are oriented in different directions, and the surface is flat.

Figs. 10 and 11 also support the idea of the present invention that because the c axes are oriented in different directions, the reoxidation of the oxygen deficiencies is inhibited and the moisture resistance is improved.

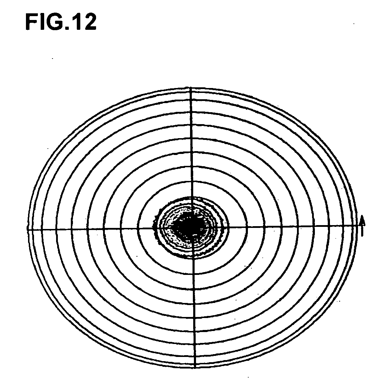

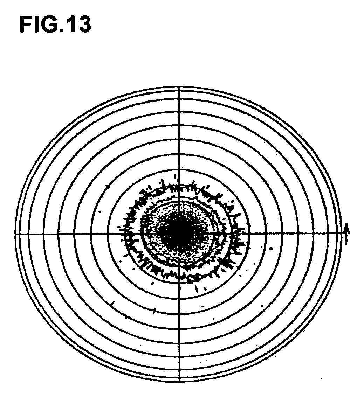

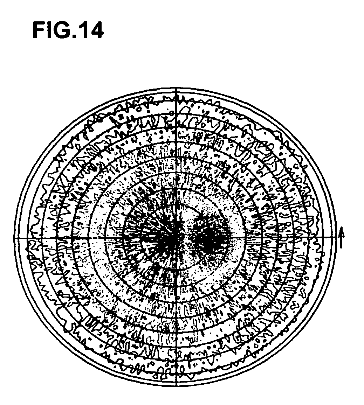

Fig. 12 is an X-ray ZnO (002) pole figure of the sample with a Ga₂O₃ dopant concentration of 4.1 wt% outside the range of the present invention, and Figs. 13 and 14 are X-ray ZnO (002) pole figures of the samples having a Ga₂O₃ dopant concentration of 12.6 wt% and 22.8 wt%, respectively, within the range of the present invention.

Fig. 12 shows that in the sample with a Ga₂O₃ dopant concentration of 4.1 wt% outside the range of the present invention, the c axes are oriented in the direction of the normal line with respect to the substrate.

In contrast, in the sample with a Ga₂O₃ dopant concentration of 12.6 wt% in the range of the present invention, the extent that the c axes are oriented in the same direction is significantly low as shown in Fig. 13 when compared with the sample outside the range of the present invention shown in Fig. 12.

In the sample with a Ga₂O₃ dopant concentration of 22.8 wt% in the range of the present invention shown in Fig. 14, the extent that the c axes are oriented in the same direction is significantly low when compared with the sample outside the range of the present invention shown in Fig. 12.

Thus, Figs. 12, 13, and 14 also support the idea of the present invention that because the c axes are oriented in different directions, the reoxidation of the oxygen deficiencies is inhibited and the moisture resistance is improved.

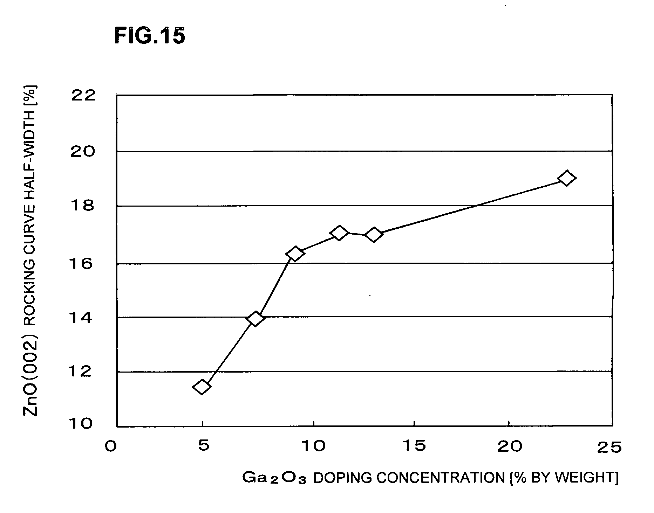

Fig. 15 is a graph showing the relationship between the Ga₂O₃ dopant concentration and the ZnO (002) rocking curve half width.

As shown in Fig. 15, at a Ga₂O₃ dopant concentration of 7 wt% or more, the ZnO (002) rocking curve half width is 13.5° or more. At a rocking half curve value of 13.5° or more, the extent of c-axes orientation of the ZnO film is moderated, and the moisture resistance is improved.

EXAMPLE 1 confirms that a transparent conductive film having a practical level of moisture resistance can be formed on an all-purpose glass substrate.

From the standpoint of achieving sufficiently low resistivity, it is most preferable to use Ga as the Group III element (dopant), but effects similar to that achieved by use of Ga can be obtained by using other Group III metals such as Al and In.

The same effects can also be achieved by using at least two types of Group III elements, namely Ga and at least one of Al and In.

The basic effects of the present invention can be obtained by adding Ga, which is a Group III element, and a dopant other than Group III elements.

### EXAMPLE 2

In EXAMPLE 1 above, the case in which a glass substrate was used as the base onto which the transparent conductive film was formed was described. In EXAMPLE 2, a substrate (flexible substrate) composed of polyethylene naphthalate (PEN) was used as the base onto which the transparent conductive film was formed, and the pre-treatment of the substrate was conducted by the same process as in EXAMPLE 1.

As in EXAMPLE 1, a ZnO sintered target having a sintered density of 80% or more and a diameter of 6 inches was prepared.

As in EXAMPLE 1, pellets (Ga₂O₃ pellets) for doping composed of gallium oxide (Ga₂O₃) and having a diameter of 10 mm were prepared.

In this EXAMPLE 2 also, the dose of Ga₂O₃ was adjusted by adjusting the number of the Ga₂O₃ pellets.

Then a Ga-doped ZnO film (transparent conductive film) was formed on a PEN substrate (flexible substrate) by sputtering using the same process, the same conditions, and the same sputtering apparatus as in EXAMPLE 1.

The resulting ZnO film was subjected to patterning by wet etching. Then, whether the thickness of the film was within the target range was inspected with a stylus profilometer.

The resistivity of the samples measured by a four-probe method was as follows:
(1) 6.7 × 10⁻⁴ Ωcm when the number of Ga₂O₃ pellets was 1
(2) 8.1 × 10⁻⁴ Ωcm when the number of Ga₂O₃ pellets was 3
(3) 3.4 × 10⁻³ Ωcm when the number of Ga₂O₃ pellets was 5 The sheet resistance was as follows:

(1) 15 Ω/□ when the number of Ga₂O₃ pellets was 1
(2) 20 Ω/□ when the number of Ga₂O₃ pellets was 3
(3) 77 Ω/□ when the number of Ga₂O₃ pellets was 5

The light transmittance in a visible region was 80% or more in all cases involving 1, 3, and 5 Ga₂O₃ pellets.

ICP quantitative analysis was conducted, and as a result, it was confirmed that the relationship between the number of Ga₂O₃ pellets and the Ga₂O₃ dopant concentration was as follows:
(1) Ga₂O₃ dopant concentration was 5.5 wt% when the number of Ga₂O₃ pellets was 1;
(2) Ga₂O₃ dopant concentration was 14.8 wt% when the number of Ga₂O₃ pellets was 3; and
(3) Ga₂O₃ dopant concentration was 28.5 wt% when the number of Ga₂O₃ pellets was 5.

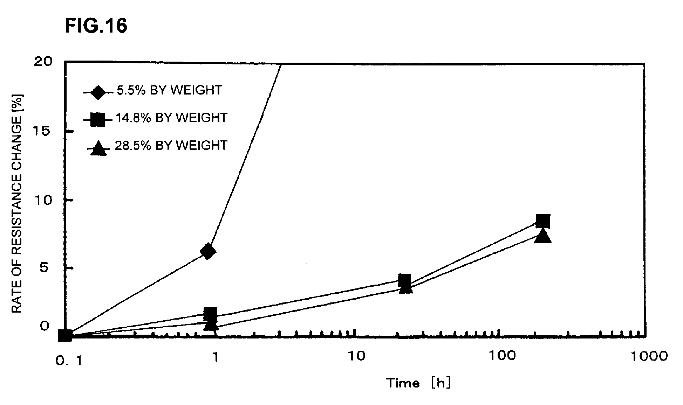

The samples prepared in EXAMPLE 2 were subjected to moisture resistance test at high temperature and high humidity. As shown in Fig. 16, the resistance dramatically increased with time for a sample having a Ga₂O₃ dopant concentration of 5.5 wt% and prepared using one Ga₂O₃ pellet. In the sample in which the number of Ga₂O₃ pellets was 3 and the Ga₂O₃ dopant concentration was 14.8 wt%, the rate of change (increase) in resistivity after 200 hours was 8.8%. In the sample in which the number of Ga₂O₃ pellets was 5 and the Ga₂O₃ dopant concentration was 28.5 wt%, the rate of change (increase) in resistivity after 200 hours was 7.8%. This confirmed that the moisture resistance could be significantly improved when compared with the sample prepared by using one Ga₂O₃ pellet (Ga₂O₃ dopant concentration: 5.5 wt%).

EXAMPLE 2 confirms that the ZnO-based transparent conductive film made by the method of the present invention can be applied to a so-called flexible device that uses a flexible substrate composed of PEN.

### EXAMPLE 3

A Ga-doped ZnO film (transparent conductive film) was made by sputtering by the same process and conditions as in EXAMPLE 2 above except that a substrate (flexible substrate) composed of polyethylene terephthalate (PET) was used instead of the substrate (flexible substrate) composed of polyethylene naphthalate (PEN) used in EXAMPLE 2.

The properties of the resulting ZnO film (transparent conductive film) were analyzed under the same conditions. It was confirmed that a ZnO film (transparent conductive film) having the same properties as in EXAMPLE 2 could be obtained.

This confirms that a practically applicable transparent conductive film can be formed on an all-purpose substrate (flexible substrate) composed of polyethylene terephthalate (PET).

### EXAMPLE 4

A glass substrate composed of non-alkali glass (Corning 1737) was prepared as the base. The glass substrate (base) was cleaned with isopropyl alcohol and UV irradiation to obtain a clean surface.

A ZnO sintered target having a sintered density of 80% or more and a diameter of 4 inches was prepared as the sputtering target.

Pellets (Ga₂O₃ pellets) composed of gallium oxide (Ga₂O₃) and having a diameter of 10 mm were prepared for doping.

In EXAMPLE 4, the Ga₂O₃ pellets were placed in an erosion region on the ZnO sintered target and sputtering was conducted to form a ZnO film doped with Ga₂O₃ on a base.

The dose of Ga₂O₃ was adjusted by adjusting the number of Ga₂O₃ pellets.

In conducting sputtering, a glass substrate was set in a vacuum chamber of a sputtering apparatus, the chamber was evacuated to 5 × 10⁻⁵ Pa, and sputtering was conducted without heating the glass substrate (base) while applying a bias voltage of -80 V.

In EXAMPLE 4, high-purity Ar gas was used as the sputtering gas, and the sputtering gas was introduced to the vacuum chamber until the pressure inside the chamber was 1 Pa.

Deposition was conducted by starting sputtering under a condition of RF power: 250 W to form a ZnO film (transparent conductive film) doped with Ga at a particular proportion and having a predetermined thickness. The thickness of the ZnO film to be deposited was set to 400 nm.

The resulting ZnO film was subjected to patterning by wet etching. Then, whether the thickness of the film was ±15% of the target thickness was inspected with a stylus profilometer.

The Ga dopant concentration of the resulting ZnO film was 4.5 wt%, and the resistivity was 8.3 × 10⁻⁴ Ωcm.

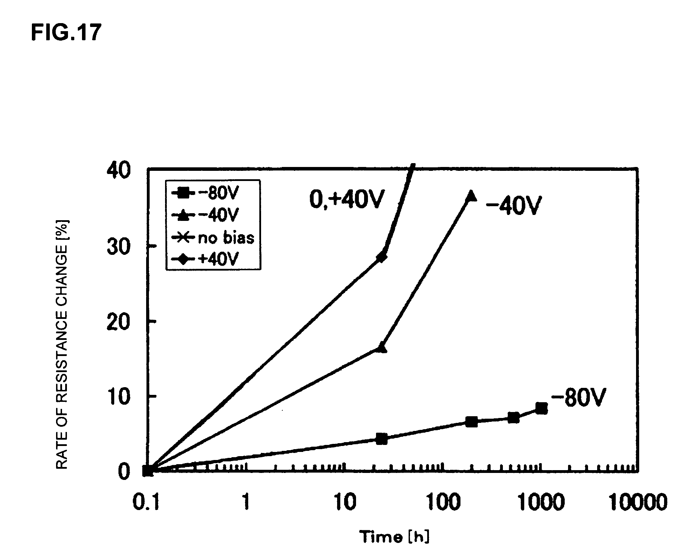

The ZnO film was subjected to moisture resistance test at 85°C and 85% RH. As shown in Fig. 17, the rate of change in resistivity after 1000 hours was +10%, which was excellent. Note that in Fig. 17, the data of the rate of change in resistivity when the bias voltage applied to the glass substrate (base) was -80 V was plotted along with the data of the rate of change in resistivity of the samples prepared by applying a bias voltage of -40 V, 0 V, and +40 V to the glass substrate.

As discussed above, it was confirmed that the ZnO film deposited by sputtering while applying a bias voltage of -80 V to the glass substrate (base) exhibited significantly improved moisture resistance, and the rate of change in resistivity after 1000 hours was as low as +10%. In order to investigate the cause of such effects, transparent conductive films were prepared by varying the bias voltage applied to the glass substrate (base), and the structural analysis was conducted.

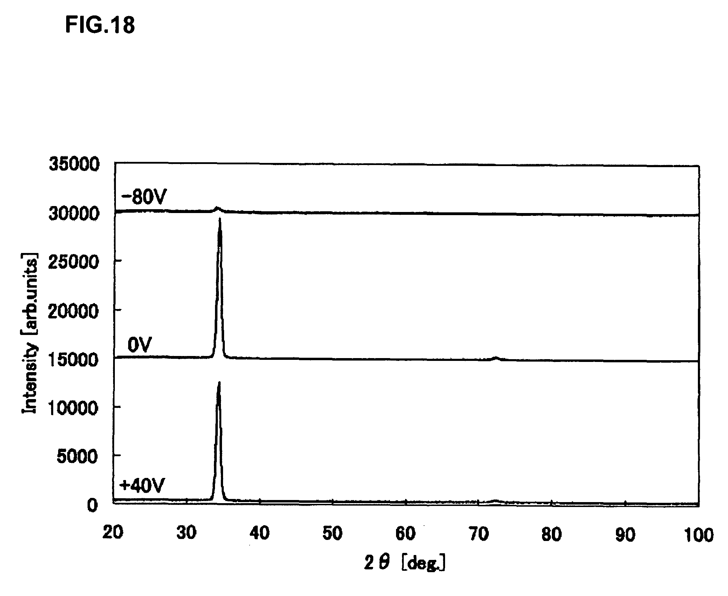

Fig. 18 is an X-ray diffractogram (θ-2θ scan) of three samples prepared under a bias voltage of -80 V, 0 V, and +40 V respectively.

As shown in Fig. 18, there was a tendency that the intensity of the c-axis peak was low when a negative bias voltage was applied compared to the cases in which a positive bias voltage was applied and no bias voltage was applied. It was confirmed that the c-axis peak substantially disappeared by application of a bias voltage of -80 V.

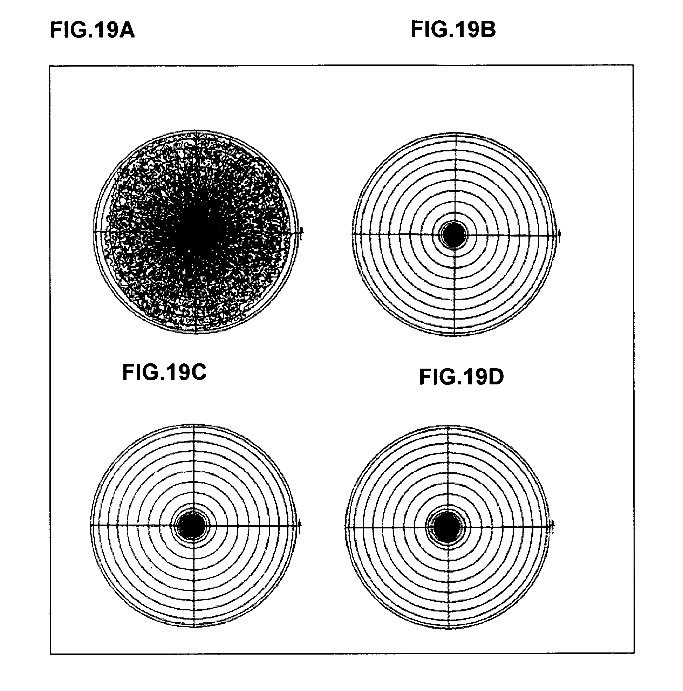

Parts (a), (b), (c), and (d) of Fig. 19 respectively show X-ray ZnO (002) pole figures of transparent conductive films prepared by applying a bias voltage of -80 V, -40 V, 0 V, and +40 V onto the base. As shown in Fig. 19(a), it was clearly confirmed that disorientation of c axes occurred in a transparent conductive film prepared by applying a bias voltage of -80 V to the glass substrate.

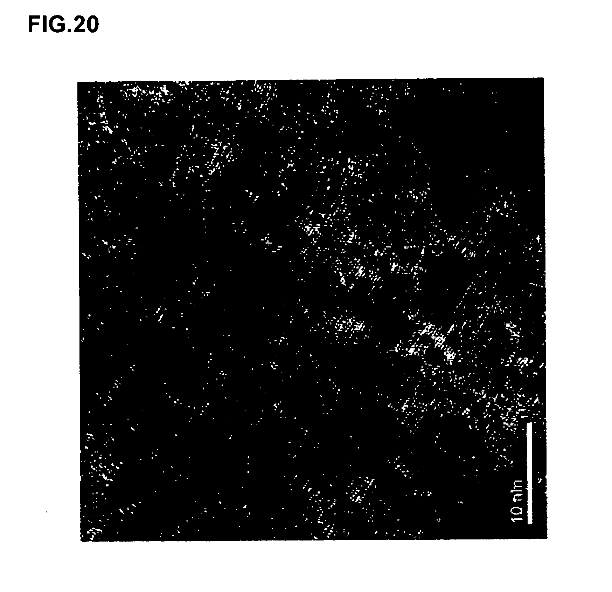

Fig. 20 is a transmission electron micrograph of the transparent conductive film prepared by applying a bias voltage of -80 V onto the glass substrate. Fig. 20 shows that, in the ZnO film prepared by applying a bias voltage of -80 V, growth occurred while the c axes are inclined and while retaining the crystal structure similar to that of the heavily doped film.

In EXAMPLES 1 to 3, it was assumed that the improvement in moisture resistance that occurred by doping the film with a Group III element (Ga) was based on the mechanism that the disorientation of the c-axes columnar structures caused by heavy doping with a Group III element (Ga) increased the activation energy of H₂O diffusion. In this example, it was assumed that the improvement in moisture resistance of the ZnO film prepared by sputtering while applying a bias voltage onto a glass substrate was attributable to the effects of Ar+ ion bombardment and suppression of growth of c-axes columnar structure resulting from trapping of Ar+ ions in the film.

Table 1 shows the results of wavelength-dispersive X-ray spectroscopy (WDX) analysis of the Ar content in the ZnO film.

**[Table 1]**

| Bias voltage (V) | Content (wt%) | | | | | | | |
|---|---|---|---|---|---|---|---|---|
| | O | Si | Ar | Ca | Zn | Ga | Sb | Ba |
| -80 | 25.8 | 2.9 | 0.6 | 0.6 | 64.3 | 3.4 | 0.4 | 2.0 |
| -80 | 24.6 | 2.5 | 0.8 | 0.5 | 66.4 | 3.1 | 0.3 | 1.8 |
| -40 | 24.3 | 1.9 | 0.2 | 0.4 | 68.3 | 2.9 | 0.5 | 1.6 |
| 0 | 23.4 | 1. 7 | 0.2 | 0.4 | 69.0 | 3.7 | 0.3 | 1.3 |
| +40 | 23.9 | 1.9 | 0.2 | 0.5 | 68.4 | 3.3 | 0.3 | 1.5 |

Table 1 shows that the amount of Ar trapped increases with the absolute value of the negative bias voltage.

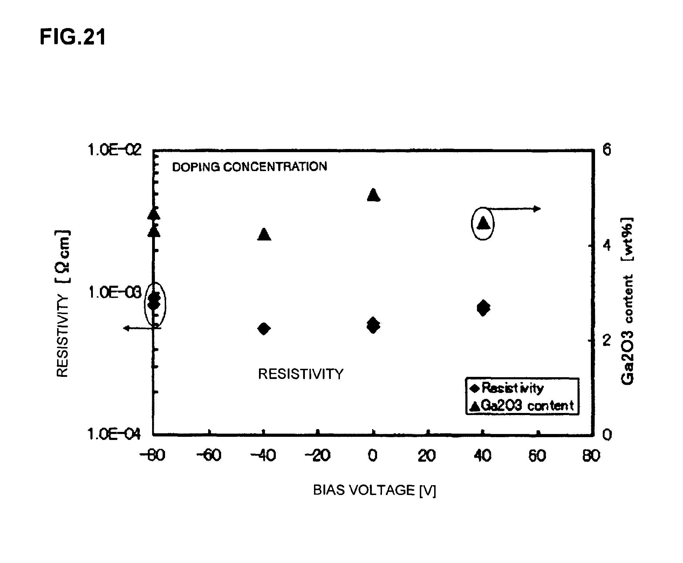

Fig. 21 is a graph showing the relationship among the bias voltage applied to the glass substrate, the resistivity, and the Ga₂O₃ dopant concentration.

Fig. 21 shows that the application of bias voltage onto the glass substrate does not substantially affect the resistivity. Thus, it is possible to achieve both low resistivity and high moisture resistance by conducting deposition while applying a bias voltage onto the glass substrate.

In the method of EXAMPLE 4 including depositing the transparent conductive film while applying a bias voltage to the glass substrate, from the standpoint of achieving sufficiently low resistivity, it is most preferable to use Ga as the Group III element (dopant), but effects similar to that achieved by use of Ga can be obtained by using other Group III metals such as Al and In. Alternatively, the same effects can also be achieved by adding Ga and at least one of Al and In.

In EXAMPLE 4, a transparent conductive film with excellent moisture resistance was obtained by forming a thin film while applying a negative bias voltage to the base. The sign of the bias voltage applied to the base and the value (absolute value) of the bias voltage are preferably optimized according to the conditions such as the type of Group III element and the dopant concentration. In some cases, it is preferable to form a thin film while applying a positive bias voltage having a value (absolute value) different from that in EXAMPLE 4.

### EXAMPLE 5

A ZnO film (transparent conductive film) doped with Ga was formed by using a substrate (flexible substrate) composed of polyethylene terephthalate (PET) instead of the non-alkali glass substrate (base) used in EXAMPLE 4 and by conducting sputtering by the same process and under the same conditions as in EXAMPLE 4 above while applying a bias voltage to the flexible substrate.

The properties of the resulting ZnO film (transparent conductive film) were analyzed under the same conditions. It was confirmed that the ZnO film (transparent conductive film) had the same properties as in EXAMPLE 4.

This confirms that a practically applicable transparent conductive film can be formed on an all-purpose substrate (flexible substrate) composed of polyethylene terephthalate (PET).

Note that although in EXAMPLES 1 to 5 above a ZnO film (transparent conductive film) was formed on a glass substrate, PEN substrate, or a PET substrate, it is also possible to form the film on a single crystal substrate such as a glass, quartz, or sapphire substrate. In this case also, the same advantages as those achieved by forming the film on a glass substrate can be obtained.

Note that although in EXAMPLES 1 to 5 above a ZnO film (transparent conductive film) was formed directly on a substrate, a ZnO film (transparent conductive film) may be formed on a SiNx thin film disposed on a substrate in the case where the substrate is a water-permeable substrate such as a flexible substrate. In this manner, the moisture resistance of the transparent conductive film can be further improved, and it is possible to decrease the rate of change in resistivity after 1000 hours by the moisture resistance test to zero.

The present invention is not limited by the examples described above with regards to other features also. It is possible to modify and alter the shape of the base onto which the transparent conductive film is formed, the type of constituent material, the type of Group III element, the dose of the dopant, specific deposition conditions of the transparent conductive film, and the like without departing from the scope of the present invention.

### Industrial Applicability

As described above, according to the present invention, it is possible to efficiently and reliably form a ZnO-based transparent conductive film having moisture resistance of a practical level, properties required as the transparent conductive film, and excellent economical efficiency.

Thus, the present invention can be widely applied to various usages including flat panel displays and transparent electrodes of solar cells.

## Claims

1. A transparent conductive film grown on a base by doping zinc oxide (ZnO) with a Group III element, the transparent conductive film comprising a region having a crystal structure in which c axes are oriented in a plurality of different directions.

2. A transparent conductive film grown on a base by doping zinc oxide (ZnO) with a Group III element, wherein a ZnO (002) rocking curve half width is 13.5° or more.

3. The transparent conductive film according to claim 1 or 2, wherein the transparent conductive film is formed as a thin film while applying a bias voltage to the base.

4. The transparent conductive film according to claim 3, wherein formation of the thin film is conducted by one technique selected from the group consisting of a sputtering technique, a vapor deposition technique, an evaporation ion plating technique, a laser ablation technique, and an arc plasma deposition technique.

5. The transparent conductive film according to any one of claims 1 to 4, wherein zinc oxide (ZnO) is contained as a main component, and an oxide of the Group III element is contained in an amount of 7 to 40 percent by weight.

6. The transparent conductive film according to any one of claims 1 to 5, wherein the transparent conductive film is formed on a SiNx thin film on the base.

7. The transparent conductive film according to any one of claims 1 to 6, wherein the base contains, as a major component, at least one selected from the group consisting of glass, quartz, sapphire, Si, SiC, polyethylene terephthalate (PET), polyethylene naphthalate (PEN), polyether sulfone (PES), polyimide, a cycloolefin polymer, and polycarbonate.

8. The transparent conductive film according to any one of claims 1 to 7, wherein the Group III element is at least one selected from the group consisting of Ga, Al, and In.

9. A method for making a transparent conductive film containing zinc oxide (ZnO) and a Group III element, the method comprising:
a step of forming, on a base, a transparent conductive film including a region having a crystal structure in which c axes are oriented in a plurality of different directions by using a starting material containing zinc oxide (ZnO) and an oxide of the Group III element and by conducting deposition on the base by a thin-film forming technique such that the dose of the oxide of the Group III element is in the range of 7 to 40 percent by weight.

10. A method for making a transparent conductive film containing zinc oxide (ZnO) and a Group III element, the method comprising:
a step of forming, on a base, a transparent conductive film having a ZnO (002) rocking curve half width of 13.5° or more by using a starting material containing zinc oxide (ZnO) and an oxide of the Group III element and by conducting deposition on the base by a thin-film forming technique such that the dose of the oxide of the Group III element is in the range of 7 to 40 percent by weight.

11. A method for making a transparent conductive film containing zinc oxide (ZnO) and a Group III element, the method comprising:
a step of forming, on a base, a transparent conductive film including a region having a crystal structure in which c axes are oriented in a plurality of different directions by using a sintered target including a composition containing zinc oxide (ZnO) and an oxide of the Group III element and by conducting deposition on the base by one technique selected from the group consisting of a sputtering technique, a vapor deposition technique, an evaporation ion plating technique, a laser ablation technique, and an arc plasma deposition technique such that the dose of the oxide of the Group III element is in the range of 7 to 40 percent by weight.

12. A method for making a transparent conductive film containing zinc oxide (ZnO) and a Group III element, the method comprising:
a step of forming, on a base, a transparent conductive film having a ZnO (002) rocking curve half width of 13.5° or more by using a sintered target including a composition containing zinc oxide (ZnO) and an oxide of the Group III element and conducting deposition on the base by one technique selected from the group consisting of a sputtering technique, a vapor deposition technique, an evaporation ion plating technique, a laser ablation technique, and an arc plasma deposition technique such that the dose of the oxide of the Group III element is in the range of 7 to 40 percent by weight.

13. The method for making the transparent conductive film containing zinc oxide (ZnO) and the Group III element according to any one of claims 9 to 12, wherein a relationship between a temperature of the base onto which the transparent conductive film is formed by the thin-film forming technique and the dose of the oxide of the Group III element is within the range defined by points a, b, and c in Fig. 4.

14. The method for making the transparent conductive film containing zinc oxide (ZnO) and the Group III element according to any one of claims 11 to 13, wherein in conducting deposition on the base by one technique selected from the group consisting of a sputtering technique, a vapor deposition technique, an evaporation ion plating technique, a laser ablation technique, and an arc plasma deposition technique, a bias voltage is applied to the base.

15. The method for making the transparent conductive film containing zinc oxide (ZnO) and the Group III element according to any one of claims 9 to 14, wherein the deposition by the thin-film forming technique is conducted in a vacuum chamber at a backpressure of 1 × 10⁻⁴ Pa or less.

16. A method for making a transparent conductive film comprising forming a SiNx thin film on a base and then forming the transparent conductive film on the SiNx thin film on the base by the method according to any one of claims 9 to 15.

17. The method for making the transparent conductive film according to any one of claims 9 to 16, wherein the base contains, as a major component, at least one selected from the group consisting of glass, quartz, sapphire, Si, SiC, polyethylene terephthalate (PET), polyethylene naphthalate (PEN), polyether sulfone (PES), polyimide, a cycloolefin polymer, and polycarbonate.

18. The method for making the transparent conductive film according to any one of claims 9 to 17, wherein the Group III element is at least one selected from the group consisting of Ga, Al, and In.
